# EUROPEAN PATENT SPECIFICATION

(11) **EP 2 237 651 B1**
(45) Date of publication and mention of the grant of the patent: **07.12.2011**
(21) Application number: 10006438.5
(22) Date of filing: 12.10.2007
(51) Int. Cl.: H05K 3/34, H05K 3/24

(54) **Method for forming solder layer on printed-wiring board and slurry discharge device**
Verfahren zur Bildung einer Lotschicht auf einer Leiterplatte und Schlammentladungsvorrichtung
Procédé permettant de former une couche de brasure tendre sur une carte de câblage imprimé et dispositif de charge de boue

(30) Priority: 17.10.2006 JP 2006282328
(43) Date of publication of application: 06.10.2010
(62) Divisional of application: 07830129.8
(73) Proprietor: SHOWA DENKO K.K., Minato-ku, Tokyo (JP)
(72) Inventor: Shoji, Takashi, Minato-ku, Tokyo 105-8518 (JP); Sakai, Takekazu, Minato-ku, Tokyo 105-8518 (JP)
(74) Representative: Strehl Schübel-Hopf & Partner

(56) References cited:
- WO-A1-02/05607
- WO-A1-86/00842
- WO-A1-2006/104238
- WO-A1-2007/029866
- US-A- 4 572 103

## Description

### Technical Field:

This invention relates to a method for forming a soldered circuit board and more particularly to a method for forming a solder layer on the surface of a fine conductive circuit on a printed-wiring board.

### Background Art:

In recent years, a printed-wiring board having a circuit pattern formed on an insulating substrate, such as plastic substrate, ceramic substrate or plastic-coated metallic substrate has been developed and a means to configure electronic circuits by having electronic parts, such as IC elements, semiconductor chips, resistors and capacitors, soldered on the circuit pattern of the printed-wiring board has been finding extensive acceptance.

In this case, for the purpose of joining the lead terminals of the electronic parts to stated positions of the circuit pattern, the generally adopted practice comprises forming a thin solder layer in advance on the surface of a conductive circuit on the substrate, printing solder paste or flux, positioning and mounting prescribed electronic parts and then soldering them by reflowing the thin solder layer or the thin solder layer and solder paste.

Recently, for the purpose of miniaturizing electronic products, the soldered circuit boards are required to pursue the trend toward fine pitching and have been copiously mounting thereon 0.3 mm-pitch QFP (quad flat package) type and CSP (chip size package) type LSI packages and 0.15 mm-pitch FCs (flip chips). As a result, the soldered circuit boards are required to have a fine soldered circuit pattern capable of answering the fine pitching.

For the purpose of forming a soldered circuit via a solder film on a printed-wiring board, the plating method, HAL (hot air leveler) method or method which comprises printing paste of solder powder and reflowing the resultant print, for example, is carried out. The method for producing the soldered circuit by the plating method, however, incurs difficulty in adding to the thickness of the solder layer and the method resorting to the printing of solder paste incurs difficulty in coping with the fine pitch pattern.

As a way of forming a soldered circuit without requiring any complicated procedure as positioning a circuit pattern, therefore, a method has been disclosed, which method comprises reacting the surface of a conductive circuit on a printed-wiring board with a tackifier compound to impart tackiness to the surface, attaching solder powder to the resultant tacky part and then heating the printed-wiring board to fuse the solder powder, thereby forming a soldered circuit (refer, for example, to JP-A HEI 7-7244).

The method disclosed in JP-A HEI 7-7244 renders it possible to form a fine soldered circuit pattern by a simple procedure and consequently provide a circuit board of high reliability. Since this method causes solder powder to adhere by a dry process to the circuit board, it entails such problems as suffering the powder to adhere even to undue parts electrostatically, inducing the power to scatter, impeding miniaturization of the circuit board and disabling efficient use of the solder powder. The present inventors have applied for a patent of the invention directed to a method that comprises immersing a printed-wiring board in slurry containing solder powder and causing solder powder to adhere by a wet process to the tacky surface of a conductive circuit (refer, for example, to JP-A 2006-278650).

In the case of the method that comprises immersing a printed-wiring board in slurry containing solder powder and causing the solder powder to adhere by a wet process to the tacky surface of a conductive circuit, however, since the solder powder is subjected to buoyancy in the slurry, it manifests a weak adhesion force as compared with the dry process. To cope with this problem, a method that comprises using a device for discharging slurry containing solder powder, exerting pressure to the slurry and consequently causing the solder powder to adhere fast to the resultant tacky circuit part is conceivable. This method, however, entails the problem that the solder powder in the slurry is crushed with a machine part, such as a pump, in the discharge device and the solder powder in the crushed shape fails to adhere homogeneously.

This invention is aimed at solving the problems mentioned above and providing a method for forming a solder layer of a soldered circuit board that avoids crushing the shape of solder powder, enables the solder powder to adhere homogeneously to the circuit board and consequently realizes a fine circuit pattern and providing a device for discharge of the slurry containing the solder powder.

WO 86/00842 discloses a method for multipoint dispensing of viscous material onto a board.

### Disclosure of the Invention:

This invention provides the following.
[1] A method for forming a solder layer on a surface of a conductive circuit on a printed-wiring board, comprising imparting tackiness to the surface, causing slurry containing solder powder to be discharged from inside a tank onto the surface of the conductive circuit utilizing a pressure generated in the tank to allow the solder powder to adhere to the surface of the conductive circuit, and heating the adhered slurry,
   characterized in that the slurry is discharged in a state in which the printed-wiring board has been immersed in water.
[2] A method for forming a solder layer according to [1], further comprising causing a gas or a solvent to be forced in or out of the tank, thereby adjusting the pressure in the tank for the slurry.

The above and other objects, characteristic features and advantages of the present invention will become apparent to those skilled in the art from the description to be given herein below with reference the accompanying drawings.

### Brief Description of the Drawings:

FIG. 1 is one example of the device for discharging slurry containing solder powder.
FIG. 2 is another example of the device for discharging slurry containing solder powder.
FIG. 3 is still another example of the device for discharging slurry containing solder powder.

### Best Mode for carrying out the Invention:

The printed-wiring used in the method of the present invention include plastic substrates, plastic film substrates, glass fabric substrates, paper-based epoxy resin substrates, substrates having a metal sheet stacked on a ceramic substrate, single-sided printed wiring boards and double-sided printed wiring boards having formed a circuit pattern by using a conductive substance, such as metal, on an insulating substrate resulting from coating a metal base with plastic or ceramic, and multiplayer printed wiring boards and flexible printed wiring boards, for example. This invention can also be applied to IC substrates, capacitors, resistors, coils, barristers, bare chips and wafers.

This invention is directed to a method for forming a solder layer on a circuit board by comprising causing the surface of a conductive circuit on the printed-wiring board to react with a tackifier compound to impart tackiness to the surface, applying solder powder to the resultant tacky part, and then heating the printed-wiring board, thereby fusing the solder powder.

As the substance for forming a circuit, copper is used in most cases. This invention does not need to limit this substance to copper and allows use of a conductive substance capable of enabling the surface to derive tackiness from the tackifier substances to be described herein below. As concrete examples of the substance, substances containing Ni, Sn, Ni-Au and solder alloy may be cited.

As the tackifier compounds used preferably by this invention, naphthotriazole-based derivatives, benzotriazole-based derivatives, imidazole-based derivatives, benzoimidazole-based derivatives, mercaptobenzothiazole-based derivatives and benzothiazolthio fatty acids may be cited. These tackifier compounds exhibit a strong effect particularly to copper and are capable of imparting tackiness to other conductive substances.

In this invention, the benzotriazole-based derivatives are represented by general formula (1): 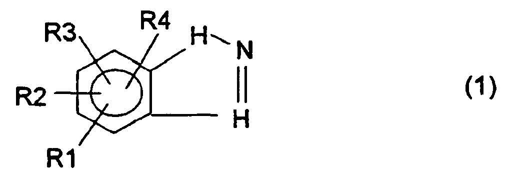 (wherein R1 to R4 independently denote a hydrogen atom, an alkyl group of 1 to 16, preferably 5 to 16 carbon atoms, an alkoxy group, F, Br, Cl, I, a cyano group, an amino group or an OH group).

The naphthotriaxole-based derivatives are represented by general formula (2): 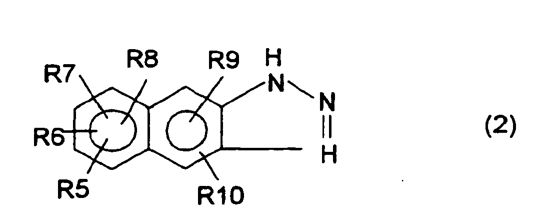 (wherein R5 to R10 independently denote a hydrogen atom, an alkyl group of 1 to 16, preferably 5 to 16 carbon atoms, an alkoxy group, F, Br, Cl, I, a cyano group, an amino group or an OH group).

The imidazole-based derivatives are represented by general formula (3): 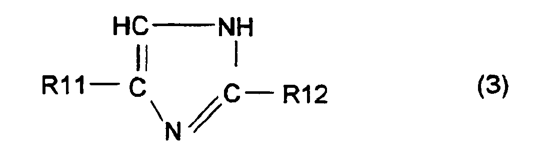 (wherein R11 and R12 independently denote a hydrogen atom, an alkyl group of 1 to 16, preferably 5 to 16 carbon atoms, an alkoxy group, F, Br, Cl, I, a cyano group, an amino group or an OH group).

The benzoimidazole-based derivatives are represented by formula (4): 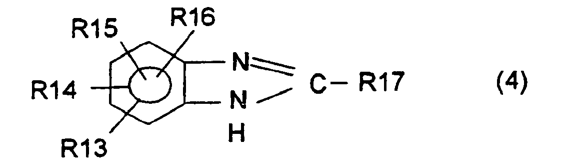 (wherein R13 to R17 independently denote a hydrogen atom, an alkyl group of 1 to 16, preferably 5 to 16 carbon atoms, an alkoxy group, F, Br, Cl, I, a cyano group, an amino group or an OH group).

The mercaptobenzothiazole-based derivatives are represented by general formula (5): 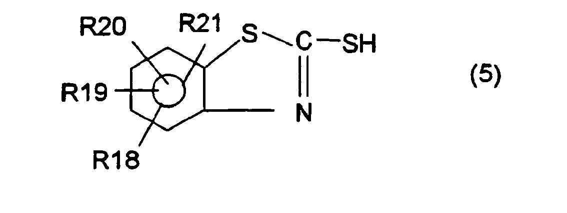 (wherein R18 to R21 independently denote a hydrogen atom, an alkyl group of 1 to 16, preferably 5 to 16 carbon atoms, an alkoxy group, F, Br, Cl, I, a cyano group, an amino group or an OH group).

The benzothiazolethio fatty acid-based derivatives are represented by general formula (6): 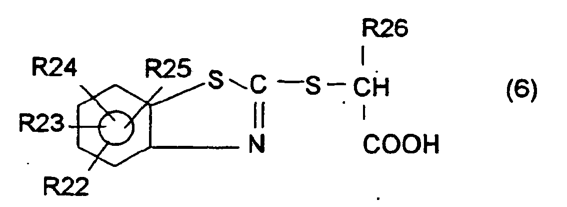 (wherein R22 to R26 independently denote a hydrogen atom, an alkyl group of 1 to 16, preferably 1 or 2 carbon atoms, an alkoxy group, F, Br, Cl, I, a cyano group, an amino group or an OH group).

Of these compounds, the benzotriazole-based derivatives represented by general formula (1) generally manifest strong tackiness in proportion as the carbon numbers of R1 to R4 increase.

The imidazole-based derivatives and the benzoimidazole-based derivatives represented by general formulae (3) and (4) generally manifest strong tackiness in proportion as the carbon numbers of R11 to R17 increase.

The benzothiazolthio fatty acid-based derivatives represented by general formula (6) prefer R22 to R26 to have 1 or 2 carbon atoms, respectively.

In this invention, at least one of the tackifier compounds is dissolved in water or acid water and preferably adjusted to weak acidity of about pH 3 to pH 4 prior to use. As substances usable for the adjustment of pH when the conductive substance is a metal, inorganic acids including hydrochloric acid, sulfuric acid, nitric acid and phosphoric acid may be cited. The organic acids usable for this purpose include formic acid, acetic acid, propionic acid, malic acid, oxalic acid, malonic acid, succinic acid and tartaric acid. Though the concentration of the tackifier compound is not rigidly limited, but is properly adjusted, depending on the solubility and the condition of use, it is preferably in the range of 0.05 mass % to 20 mass % as a whole. If the concentration is lower than this range, the tacky film will not be formed sufficiently and will prove unsatisfactory in performance.

The temperature of the treatment prefers to be slightly elevated from room temperature for the sake of the speed and the amount of the formation of the tacky film. While it is not limited because it is variable with the concentration of the tackifier compound and the kind of the metal, it is generally proper in the range of 30°C to 60°C. While the duration of the immersion is not limited, it is preferable from the viewpoint of the efficiency of operation to adjust other conditions so that the duration may fall in the approximate range of 5 seconds to 30 minutes.

In this case, the presence of copper in a concentration of 30 to 1000 ppm as ions in the solution is advantageous in enhancing the efficiency of formation, such as the speed and the amount of the formation of the tacky film

The printed-wiring board to be processed is preferably prepared in such a state that the solder-free conductive circuit part may be covered with resist, for example, and the circuit pattern will be alone left exposed and then subjected to a treatment with the solution of a tackifier compound.

The surface of the conductive circuit exhibits tackiness when the printed-wiring board is immersed in a solution of the tackifier compound used herein or the solution is applied to the surface.

This invention relates to the method for discharging the slurry containing solder powder to the tacky part of the conductive circuit surface. In the case of inducing the adhesion of the solder powder to the tacky part of the circuit surface, a method that comprises immersing the printed-wiring board in the slurry, thereby causing the adhesion of the solder powder may be conceived. Since the solder powder is susceptible to buoyancy in the slurry as described previously, the adhesive force thereof may be low as compared with the dry process. When the discharge pipe is provided with a pump and a valve, these components will be at a disadvantage in crushing the solder particles.

This invention, therefore, is directed, on the occasion of causing the adhesion of the solder powder, to providing a method for discharging the slurry by dint of the pressure generated in the tank without requiring the discharge pipe to be provided with a pump or a valve. Thus, the slurry is pressed and the solder powder is caused to adhere fast to the circuit part to which tackiness has been imparted.

The adjustment of the pressure in this case is accomplished by feeding gas such as air, or water such as a solvent having the slurry dispersed therein, to the tank or releasing it from the tank. When the pressure is to be heightened, it suffices to feed gas into the tank. When the pressure is to be lowered, it suffices to discharge the gas from the tank. This pressure enables the speed of the discharge of the slurry to be controlled.

The present invention uses a method of discharging slurry onto the circuit portion in a state in which a printed-wiring board has been immersed in water.

Thus, part of the solder powder in the discharged slurry, having not adhered to the circuit portion, can effectively be recovered without being solidified.

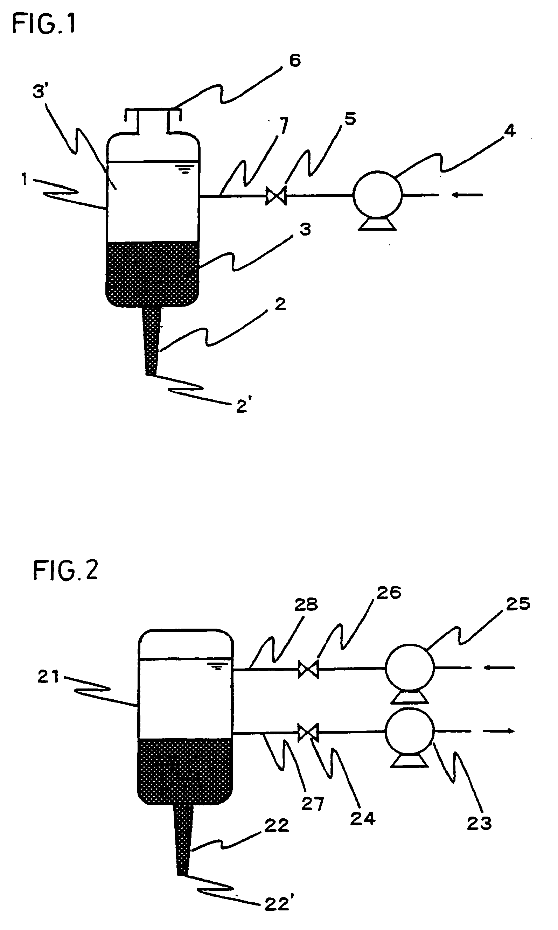

The device used for discharging the slurry containing solder powder is provided with a tank 1 for storing slurry 3 (in FIG. 1, the slurry is separated into a solder powder part and a solvent part in the tank), a slurry discharge pipe 2 disposed in the tank, a discharge port 2', a delivery pipe 7 connected to the tank and adapted to handle gas such as air or a solvent, and a pump 4 or switch valve 5 disposed in the delivery pipe and adapted to release the slurry stored in the tank via the discharge port. Reference numeral 6 denotes a supply port for supplying the slurry containing solder power to the tank 1.

In the device shown in FIG. 1, the slurry introduced into the tank 1 via the supply port 6 is released via the slurry discharge pipe 2 by pressing the tank 1 with the compressed air supplied by the pump 4 and the switch valve 5 or the solvent constituting the slurry. According to the slurry discharge device of this configuration, it is made possible to supply the solder powder stable in shape because the solder powder contained in the slurry does not pass the pump and the switch valve and has no possibility of being crushed by the machine parts, such as the pump and the switch valve.

Another device for discharging the slurry containing solder powder, as shown in FIG. 2, is provided with a tank 21 for storing the slurry, a slurry discharge and suction pipe 22 disposed in the tank and used for discharge of the slurry and suction of the slurry in common, a suction pipe 27 for the air to be used for sucking the slurry via the discharge and suction pipe 22 and storing it in the tank 21, a first pump 23 and a switch valve 24 disposed in the suction pipe 27, a delivery pipe 28 for the air to be used for releasing the slurry stored in the tank via the discharge port, and a second pump 25 and a switch valve 26 disposed in the delivery pipe 28.

In the device of this configuration, the slurry introduced into the tank 21 via the discharge and suction pipe 22 can be released via a port 22' of the discharge and suction pipe 22 by pressing the tank with the compressed air supplied by the second pump 25 and the second switch valve 26 or the solvent constituting the slurry.

According to the slurry discharge device of the configuration described above, it is made possible to supply the solder powder stable in shape because the solder powder contained in the slurry stored in the tank does not pass the pump and the switch valve and has no possibility of being crushed by the machine parts, such as the pump and the switch valve.

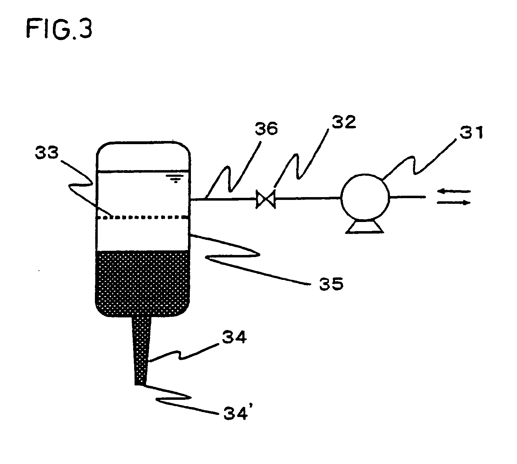

The discharge device used for the slurry containing solder powder and configured as illustrated in FIG. 2 may be modified to a configuration which, as shown in FIG. 3, has the suction pipe as for air, the delivery pipe, the first pump and the first switch valve and the second pump and the second switch valve disposed therein consolidated into an assembly consisting of a switching delivery pipe 36 as for air, a pump 31 and a valve 32 plus a filter 33 allowing no passage of the solder powder in the tank. The filter is disposed in the lower part of the position at which a switching delivery pipe 36 is attached to the tank. Thus, the solder powder has no possibility of passing the pump 31 and the valve 32. In this device, the operation of sucking and discharging the slurry via a discharge and suction port 34' of a discharge and suction pipe 34 is carried out by reversing the motion of the pump 31 and the possibility that the solder powder stored in a tank 35 will flow into the pump 31 and the switch valve 32 and consequently the solder powder will be crushed by the machine parts, such as the pump and the switch valve, is nil. By the device of this configuration, it is made possible to supply the solder powder stable in shape.

In the method that forms a solder circuit by imparting tackiness to the surface of a conductive circuit on a printed-wiring board, causing the slurry containing solder powder to be discharged to the resultant tacky part, thereby inducing adhesion of the solder power thereto, and then heating the printed-wiring board, thereby fusing the solder powder, the use of the discharge device described above can materialize a method for forming a solder circuit that does not pass the solder powder through the pump or the switch valve in the discharging device.

In the slurry containing the solder powder that is used for this invention, the concentration of the solder powder in the slurry is set preferably in the range of 0.5 volume % to 10 volume % and more preferably in the range of 3 volume % to 8 volume %.

The slurry containing the solder powder that is used in this invention prefers to use water as its solvent. For the purpose of preventing the solder powder from being oxidized with water, it is favorable to use deoxidized water or add corrosion inhibitor to the water.

The method of the treatment contemplated by this invention can be effectively used not only for the aforementioned solder precoat circuit board but also for the formation of bumps aimed at joining a BGA (ball grid array) or a CSP (chip size package).

The metallic compositions for the solder powder to be used in the method for producing the solder circuit board of this invention include Sn-Pb-based, Sn-Pb-Ag-based, Sn-Pb-Bi-based, Sn-Pb-Bi-Ag-based and Sn-Pb-Cd-based compositions, for example. From the recent viewpoint of excluding Pb from industrial wastes, Sn-In-based, Sn-Bi-based, In-Ag-based, In-Bi-based, Sn-Zn-based, Sn-Ag-based, Sn-Cu-based, Sn-Sb-based, Sn-Au-based, Sn-Bi-Ag-Cu-based, Sn-Ge-based, Sn-Bi-Cu-based, Sn-Cu-Sb-Ag-based, Sn-Ag-Zn-based, Sn-Cu-Ag-based, Sn-Bi-Sb-based, Sn-Bi-Sb-Zn-based, Sn-Bi-Cu-Zn-based, Sn-Ag-Sb-based, Sn-Ag-Sb-Zn-based, Sn-Ag-Cu-Zn-based and Sn-Zn-Bi-based compositions each containing no Pb are preferably used.

As concrete examples of the foregoing metallic compositions, the eutectic solder consisting of 63 mass % of Sn and 37 mass % of Pb (hereinafter expressed as 63Sn-37Pb) and playing a central role, 62Sn-36Pb-2Ag, 62.6Sn-37Pb-0.4Ag, 60Sn-40Pb, 50Sn-50Pb, 30Sn-70Pb, 25Sn-75Pb, 10Sn-88Pb-2Ag, 46Sn-8Bi-46Pb, 57Sn-3Bi-40Pb, 42Sn-42Pb-14Bi-2Ag, 45Sn-40Pb-15Bi, 50Sn-32Pb-18Cd, 48Sn-52In, 43Sn-57Bi, 97In-3Ag, 58Sn-42In, 95In-5Bi, 60Sn-40Bi, 91Sn-9Zn, 96.5Sn-3.5Ag, 99.3Sn-0.7Cu, 95Sn-5Sb, 20Sn-80Au, 90Sn-10Ag, 90Sn-7.5Bi-2Ag-0.5Cu, 97Sn-3Cu, 99Sn-1Ge, 92Sn-7.5Bi-0.5Cu, 97Sn-2Cu-0.8Sb-0.2Ag, 95.5Sn-3.5Ag-1Zn 95.5Sn-4Cu-0.5Ag, 52Sn-45Bi-3Sb, 51Sn-45Bi-3Sb-1Zn, 85Sn-10Bi-5Sb, 84Sn-10Bi-5Sb-1Zn, 88.2Sn-10Bi-0.8Cu-1Zn, 89Sn-4Ag-7Sb, 88Sn-4Ag-7Sb-1Zn, 98Sn-1Ag-1Sb, 97Sn-1Ag-1Sb-1Zn, 91.2Sn-2Ag-0.8Cu-6Zn, 89Sn-8Zn-3Bi, 86Sn-8Zn-6Bi and 89.1Sn-2Ag-0.9Cu-8Zn are cited. The solder powder to be used in this invention may be a mixture of two or more different compositions.

Since the thickness of the solder film to be formed can be adjusted by varying the particle diameter of the solder powder, the particle diameter of the solder powder is selected based on the thickness of the solder coat. Japanese Industrial Standards (JIS), for example, select the thickness from the powders having specified diameters in the ranges of 63 to 22 µm, 45 to 22 µm and 38 to 22 µm determined by screening and balls having diameters exceeding 80 µm. For the determination of the average particle diameter of the solder powder used in the method of this invention, the method that uses a standard sieve and a simple balance as specified by JIS can be adopted. The determination may be otherwise accomplished by the image analysis with a microscope or a Coulter counter based on the electrozone method. As regards the Coulter counter, the principle thereof is entered in "Powder Technology Handbook" (compiled by the Society of Powder Technology, Japan, 2nd edition, pp 19-20). This counter determines the particle diameter distribution of powder by causing a solution having the powder dispersed therein to pass through a fine hole opened in a diaphragm and measuring the change in electric resistance on both sides of the fine hole. It can determine the ratio of pieces of particle diameter with high repeatability. The average particle diameter of the solder powder used in the method of this invention can be determined by using the method described above.

The solder circuit board fabricated by this invention can be advantageously used for the method of mounting electronic parts that comprises the steps of mounting electronic parts and joining the electronic parts by reflowing solder. The electronic parts can be joined to the parts of the solder circuit board fabricated by this invention that require their adhesion by applying solder paste to the parts as by the printing method, mounting the electronic parts in position, then heating them, thereby fusing the solder powder in the solder paste, and hardening the fused solder powder, for example.

As a means for joining the electronic parts to the solder circuit board, the surface-mount technology (SMT) may be used. This mounting method starts from preparing a solder circuit board by this invention or by the method for printing the solder paste. The solder paste is applied to the portions of the circuit pattern that require adhesion of electronic parts. Then the electronic parts, such as chip parts and QFP, to which solder has been attached or reflowed by the method of this invention are mounted on the solder paste of the circuit pattern and are collectively soldered thereto by the heat source of reflow. As the heat sources of reflow, an air-heating furnace, an infrared furnace, condensation soldering equipment and light beam soldering equipment may be used.

In the process of reflow of this invention, the preheating temperature is 130 to 180°C, preferably 130 to 150°C, and the preheating time is 60 to 120 seconds, preferably 60 to 90 seconds. The reflow temperature is +20 to +50°C based on the melting point of the alloy to be used, preferably +20 to +30°C based on the melting point of the alloy, and the reflow time is 30 to 60 seconds, preferably 30 to 40 seconds.

The reflow process can be carried out in nitrogen or in the air. In the case of the nitrogen reflow, by keeping the oxygen concentration of 5 volume % or less, preferably 0.5 volume % or less, it is made possible to enhance the wettability of the solder circuit with the solder and reduce the occurrence of solder balls as compared with the air reflow and ensue stable treatment.

Thereafter, the solder circuit board is cooled to complete the surface mounting. The method for the production of electronic part joints according to this method of mounting may be carried out on both sides of a printed-wiring board. As the electronic parts that can be used for the method for mounting electronic parts that is contemplated by this invention, LSI, resistors, capacitors, transformers, inductances, filters, oscillators and transducers may be cited, though not exclusively.

Now, this invention will be described with reference to an example.

### Example: (not belonging to the scope of the present invention)

A printed-wiring board having the minimum electrode interval of 50 µm and an electrode diameter of 80 µm was fabricated. Copper was used for a conductive circuit.

As the tackifier compound solution, a 2 mass % aqueous solution of an imidazole-based compound having C₁₁H₂₃ as the alkyl group of R12 and a hydrogen atom as R11 in general formula (3) was adjusted to a pH of about 4 with acetic acid prior to use. This aqueous solution was heated to 40°C. In the heated aqueous solution, the printed-wiring board pretreated with an aqueous hydrochloric acid solution was immersed for three minutes to form a tacky substance on the surface of the copper circuit.

The slurry containing solder powder was produced by mixing about 20 g of solder powder of 96.5Sn-3.5Ag having an average particle diameter of 70 µm (the average particle diameter of the solder powder determined by the use of a Microtrac®) with about 100 g of deoxidized pure water.

The device used for discharging the slurry containing the solder powder was configured as illustrated in FIG. 2.

The slurry containing the solder powder produced as described above was sucked via the slurry discharge and suction pipe 22 in FIG. 2 into the tank 21 by opening the switch valve 24. Then, the discharge port 22' was set on the substrate to which tackiness had been imparted. This time, the switch valve 26 was opened to discharge the slurry containing the solder powder so as to cover the substrate.

Subsequently, the excess solder powder existing on the substrate was rinsed with pure water and the wet substrate was dried.

The powder so rinsed was recovered and used again for the attachment of solder powder.

The printed-wiring board was placed in an oven at 240°C to fuse the solder powder and form solder bumps of 96.5Sn-3.5Ag in a thickness of about 50 µm on the copper circuit part. In the soldered circuit, bridges and the like were not formed at all.

### Industrial Applicability:

In a method for producing an electronic circuit board by imparting tackiness to a metal exposed part on a substrate, thereby inducing adhesion of solder powder to the taky part, and then heating the printed-wiring board, thereby fusing the solder and forming a soldered circuit, this invention has perfected a method that enables production of an electronic circuit board of markedly enhanced reliability while effectively reducing the short circuit with the solder metal between the adjacent circuit patterns even in a fine circuit pattern. As a result, a circuit board possessing a fine circuit pattern, manifesting high reliability and having mounted circuit parts allows miniaturization and impartation of high reliability. Thus, it is made possible to provide an electronic circuit board, a circuit board having mounted electronic parts exhibiting high reliability and realizing high mounting density, and an electronic device of excellent characteristics.

## Claims

1. A method for forming a solder layer on a surface of a conductive circuit on a printed-wiring board, comprising imparting tackiness to the surface, causing slurry containing solder powder to be discharged from inside a tank onto the surface of the conductive circuit utilizing a pressure generated in the tank to allow the solder powder to adhere to the surface of the conductive circuit, and heating the adhered slurry,
**characterized in that** the slurry is discharged in a state in which the printed-wiring board has been immersed in water.

2. A method for forming a solder layer according to claim 1, further comprising causing a gas or a solvent to be forced in or out of the tank, thereby adjusting the pressure in the tank for the slurry.

## Patentansprüche

1. Verfahren zum Bilden einer Lötschicht auf einer Oberfläche einer leitenden Schaltung auf einer Leiterplatte, umfassend das Versehen der Oberfläche mit Klebkraft, Veranlassen, dass Lötpulver-enthaltende Aufschlämmung von innerhalb eines Behälters unter Ausnutzung eines in dem Behälter erzeugten Drucks auf die Oberfläche der leitenden Schaltung abgegeben wird, um zu ermöglochen, dass das Lötpulver an der Oberfläche der leitenden Schaltung haftet, und Erhitzen der angehafteten Aufschlämmung,
**dadurch gekennzeichnet, dass** die Aufschlämmung in einem Zustand abgegeben wird, bei dem die Leiterplatte in Wasser eingetaucht worden war.

2. Verfahren zum Bilden einer Lötschicht nach Anspruch 1, welches weiterhin umfasst, dass ein Gas oder ein Lösungsmittel in oder aus dem Behälter gebracht wird, um so den Druck in dem Behälter für die Aufschlämmung einzustellen.

## Revendications

1. Procédé destiné à former une couche de soudure sur une surface d'un circuit conducteur sur une plaque de circuit imprimé, comportant le fait de donner un caractère collant à la surface, d'amener de la pâte contenant de la poudre de soudure à être délivrée depuis l'intérieur d'un réservoir sur la surface du circuit conducteur en utilisant une pression générée dans le réservoir afin de permettre à la poudre de soudure d'adhérer à la surface du circuit conducteur, et de chauffer la pâte collée,
**caractérisé en ce que** la pâte est délivrée dans un état dans lequel la plaque de circuit imprimé a été immergée dans l'eau.

2. Procédé destiné à former une couche de soudure selon la revendication 1, comportant en outre le fait d'amener un gaz ou un solvant à être forcé dans ou hors du réservoir, en ajustant ainsi la pression dans le réservoir pour la pâte.
